# EUROPEAN PATENT SPECIFICATION

(11) **EP 3 904 846 B1**
(45) Date of publication and mention of the grant of the patent: **25.11.2026**
(21) Application number: 20172220.4
(22) Date of filing: 29.04.2020
(51) Int. Cl.: G01J 3/10, G01J 3/42, G01N 21/3504, G01N 21/17

(54) **THERMAL EMITTER WITH EMBEDDED HEATING ELEMENT**
WÄRMESTRAHLER MIT EINGEBETTETEM HEIZELEMENT
ÉMETTEUR THERMIQUE À ÉLÉMENT CHAUFFANT INTÉGRÉ

(43) Date of publication of application: 03.11.2021
(73) Proprietor: Infineon Technologies AG, 85579 Neubiberg (DE)
(72) Inventor: Glacer, Christoph, 81827 München (DE); Barzen, Stefan, 81671 München (DE); Reinwald, Matthias, 93164 Laaber (DE)
(74) Representative: Hersina, Günter

(56) References cited:
- EP-A1- 1 789 760
- JP-A- H08 264 844
- US-A1- 2014 291 704
- US-A1- 2019 246 459
- BHATTACHARYYA P: "Technological Journey Towards Reliable Microheater Development for MEMS Gas Sensors: A Review", IEEE TRANSACTIONS ON DEVICE AND MATERIALS RELIABILITY, IEEE SERVICE CENTER, PISCATAWAY, NJ, US, vol. 14, no. 2, 1 June 2014 (2014-06-01), pages 589 - 599, XP011550087, ISSN: 1530-4388, [retrieved on 20140603], DOI: 10.1109/TDMR.2014.2311801
- LEFEBVRE ANTHONY ET AL: "Optimization of a radiative membrane for gas sensing applications", PROCEEDINGS OF SPIE, IEEE, US, vol. 9141, 15 May 2014 (2014-05-15), pages 91410G - 91410G, XP060038066, ISBN: 978-1-62841-730-2, DOI: 10.1117/12.2052273

## Description

### Technical Field

Embodiments of the present disclosure relate to an emitter, for example, an infrared emitter with an embedded heating element. The present disclosure further relates to a MEMS infrared radiation source with an embedded heating element and plasmonic structures. Thus, embodiments relate to the technology to provide an infrared (IR) radiation source, i.e. an IR or thermal emitter.

### Background

The sensing of environmental parameters in the ambient atmosphere, such as noise, sound, temperature and gases, e.g. environmental gas components, gains more and more importance in the implementation of appropriate sensors within mobile devices, home automation such as smart home, and the auto-motive sector. Harmful gas concentrations can occur due to pollution and/or a malfunction of certain devices. However, the well-being of a person or animal is strongily influenced by the air quality. Thus, the gas detection in the environmental atmosphere by inexpensive, always available and connected sensors is an upcoming topic in the future.

In the field of monitoring the air quality in our environment, there are several types of gas-sensing concepts, for example, the non-dispersive infrared (NDIR) sensors, chemical sensors and photo-acoustical sensors (PAS = photoacoustic spectroscopy). A sensor effect often used bases on the excitation of gas molecules in a medium by (infrared) light with a certain wavelength. However, currently available NDIR or PAS systems are relatively expensive due to their complex setups or special components. Further, chemical sensors show a relatively poor selectivity compared to single-wavelength or filter containing optical systems. A typical optical sensor, e.g. a PAS sensor, comprises a radiation source, fillter elements for a wavelength selection, a detector and the sample area where the light between the light source and the detector interacts with the environmental medium.

Current thermal emitters for infrared or mid-infrared radiation are usually miniaturized light bulbs or MEMS emitters with metallic heating elements, such as tungsten or platinum. Surface micro-machined or MEMS emitters with metallic heaters are typically limited to operating temperatures below 600°C to prevent degradation. This results in a significant reduction of the optical output power. Metallic conductors typically have a very low emissivity further resulting in a reduced output. The thermal mass of current emitters is high, causing a slow switching speed thereof. Moreover, the thermal resistance is low which results in a reduced energy efficiency (= less temperature increase per Watt input power).

US 2019 / 0 246 459 A1 relates to an emitter structure and a production method.

EP 1 789 760 B1 relates to a sealed infrared radiation source, comprising an emitter membrane being stimulated by an electrical current conducted through the membrane.

XP 011 550 087 relates to microheaters for MEMS gas sensors.

JP H08 264 844 A relates to a floating membrane.

XP 060 038 066 relates to an optimization of a radiative membrane for gas sensing applications.

With the evermore extensive use of gas sensors, there is a particular need to be able to produce such gas sensors having thermal emitters as inexpensively as possible and, thus, cost effectively. However, the resulting reliability and accuracy of the gas sensors should nevertheless be maintained or even increased.

Generally, there is a need in the field of sensors for an approach to provide a thermal emitter, e.g. for a gas sensor or a fluid sensor, having a relatively high thermal resistance (= low thermal mass) for achieving a relatively high energy efficiency (= high optical output power increase per electrical input power increase = high temperature increase per Watt input power) and which can be operated at relatively high operating temperatures.

Such a need can be solved by the thermal emitter according to claim 1. Further, specific implementations of the thermal emitter are defined in the dependent claims.

Accordingly, the present disclosure describes a possible thermal emitter which, for example, may be part of a MEMS gas or fluid sensor that is able to sense simultaneously at least one component of the environmental atmosphere. The thermal emitter for infrared or mid-infrared radiation can be used in any MEMS device having an IR radiation source.

### Brief description of the figures:

In the following, embodiments will be described in the following while making reference to the accompanying drawings in which:
- Fig. 1a: shows a schematic top 3D view of a thermal emitter according to an embodiment;
- Fig. 1b: shows a schematic (lateral) temperature profile of the thermal emitter according to an embodiment;
- Fig. 2: shows a schematic bottom 3D view of the thermal emitter according to an embodiment;
- Fig. 3a: shows a schematic top partial view of a thermal emitter according to an embodiment;
- Fig. 3b: shows a schematic cross-sectional partial view of a thermal emitter along a dashed intersection line A of the thermal emitter of Fig. 3a according to an embodiment;
- Fig. 4a: shows a schematic top partial view of a thermal emitter according to an embodiment;
- Fig. 4b: shows a schematic partial cross-sectional view of a thermal emitter along a dashed intersection line B of the thermal emitter of Fig. 4a according to an embodiment;
- Fig. 5a: shows a schematic cross-sectional partial view of a thermal emitter with fully embedded plasmonic structures according to an embodiment;
- Fig. 5b: shows a schematic cross-sectional partial view of a thermal emitter with partially embedded plasmonic structures according to an embodiment;
- Fig. 5c: shows a schematic cross-sectional partial view of a thermal emitter with at least partially exposed plasmonic structures according to an embodiment;
- Fig. 5d: shows a schematic cross-sectional partial view of a thermal emitter with a plasmonic resonator according to an embodiment;
- Fig. 6a: shows a schematic cross-sectional view of a MEMS gas or fluid sensor according to an embodiment; and
- Fig. 6b: shows a schematic cross-sectional view of a MEMS gas or fluid sensor according to an embodiment.

Before discussing the present embodiments in further detail using the drawings, it is pointed out that in the figures and the specification identical elements and elements having the same functionality and/or the same technical or physical effect are usually provided with the same reference numbers or are identified with the same name, so that the description of these elements and of the functionality thereof as illustrated in the different embodiments are mutually exchangeable or may be applied to one another in the different embodiments.

### Detailed description of illustrative embodiments

In the following description, embodiments are discussed in detail, however, it should be appreciated that the embodiments provide many applicable concepts that can be embodied in a wide variety of a thermal emitter. The specific embodiments discussed are merely illustrative of specific ways to implement and use the present concept, and do not limit the scope of the embodiments. In the following description of embodiments, the same or similar elements or elements that have the same functionality are provided with the same reference sign or are identified with the same name, and a repeated description of elements provided with the same reference number or being identified with the same name is typically omitted. In the following description, a plurality of details is set forth to provide a more thorough explanation of embodiments of the disclosure.

However, it will be apparent to one skilled it the art that other embodiments may be practiced without these specific details. In other instances, well-known structures and devices are shown in block diagram form rather than in detail in order to avoid obscuring examples described herein. In addition, features of the different embodiments described herein may be combined with each other, unless specifically noted otherwise.

It is understood that when an element is referred to as being "connected" or "coupled" to another element, it may be directly connected or coupled to the other element, or intermediate elements may be present. Conversely, when an element is referred to as being "directly" connected to another element, "connected" or "coupled," there are no intermediate elements. Other terms used to describe the relationship between elements should be construed in a similar fashion (e.g., "between" versus "directly between", "adjacent" versus "directly adjacent", and "on" versus "directly on", etc.).

For facilitating the description of the different embodiments, the figures comprise a Cartesian coordinate system x, y, z, wherein the x-y-plane corresponds, i.e. is parallel, to a first main surface region of a substrate (= a reference plane = x-y-plane), wherein the direction vertically up with respect to the reference plane (x-y-plane) corresponds to the "+z" direction, and wherein the direction vertically down with respect to the reference plane (x-y-plane) corresponds to the "-z" direction. In the following description, the term "lateral" means a direction parallel to the x- and/or y-direction, i.e. parallel to the x-y-plane, wherein the term "vertical" means a direction parallel to the z-direction.

In the following description, a thickness of an element usually indicates a vertical dimension of such an element. In the figures, the different elements are not necessarily drawn to scale. Thus, the thicknesses of certain elements, for example thicknesses of the freestanding membrane, the semiconductor substrate, the insulating layer, the heavily doped semiconductor layer and/or the disc-shaped heat spreader structure may not be drawn to scale.

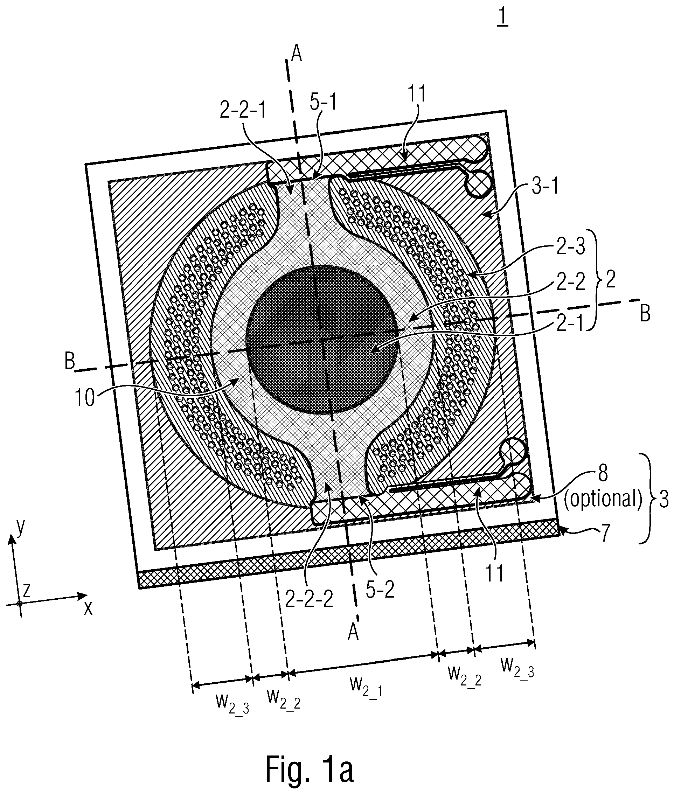

Fig. 1a shows a schematic top 3D (= three dimensional) view of a thermal emitter 1 according to an embodiment. In Fig. 1a, the drawing plane is essentially parallel to the x-y-plane. The thermal emitter 1 comprises a freestanding membrane 2 supported by a substrate 3, wherein the freestanding membrane 2 comprises in a lateral extension a center section 2-1, a conductive (= electrically conductive) intermediate section 2-2 and a border section 2-3, wherein the conductive intermediate section 2-2 laterally surrounds the center section 2-1 and is electrically isolated from the center section 2-1. The conductive intermediate section 2-2 comprises a conductive (= electrically conductive) semiconductor material which is encapsulated in an insulating material. The border section 2-3 at least partially surrounds the intermediate section 2-2 and is electrically isolated from the conductive intermediate section 2-2, wherein a perforation 4 is formed through the border section 2-3.

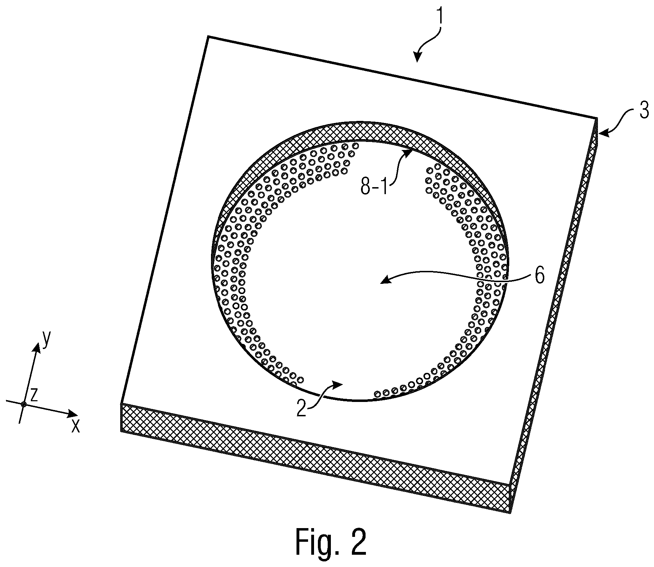

In other words, the free standing membrane 2 supported by the substrate 3 may be segmented (= partitioned) into three sections, the (inner) center section 2-1, the conductive intermediate section 2-2 and the (outer) border section 2-3, which, for example, are supported by a substrate 3 (e.g. arranged on or at a substrate). According to an embodiment, the border section 2-3 may be mechanically bonded to the substrate 3, wherein the center section 2-1, the intermediate section 2-2 and at least partially the border section 2-3 of the freestanding membrane 2 are arranged on a cavity 6 (see Fig. 2) in the substrate 3.

The center section 2-1 and the boarder section 2-3 may comprise one layer or a plurality of layers. In case of a plurality of layers, the layers of the center section 2-1 may comprise the same material or, alternatively, a different material, for example. The same applies to the border section 2-3. The intermediate section 2-2 comprises a plurality of layers, for example, at least two layers, such that a conductive semiconductor layer is encapsulated in an insulating material layer.

Thus, the freestanding membrane 2 is divided in at least three sections, i.e. the center section 2-1, the conductive intermediate section 2-2 and the border section 2-3, and is supported by the substrate 3. As the conductive intermediate section 2-2 is encapsulated (= passivated) in an insulating material, the conductive intermediate section 2-2 is electrically insulated from the center section 2-1 and the border section 2-3. The substrate 3 may comprise a bulk semiconductor substrate 7 and an optional insulating layer 8, wherein the insulating layer 8 may form a main surface region 3-1 of the substrate 3 to which the freestanding membrane 2 is mechanically attached. Further, the insulating layer 8 may comprise an opening 8-1 for at least partially or completely exposing the cavity 6 from the backside (see Fig. 2).

Based on the construction of the thermal emitter 1, such a radiation source, e.g. for a gas sensor or fluid sensor, can provide from the system side a number of requirements, such as a small and compact size, low cost, high radiation output, high energy efficiency, high switching speed, high lifetime and bandwidth. As the thermal emitter 1 has a relatively high thermal resistance (= low thermal mass) a relatively high energy efficiency (= high temperature increase per Watt input power) can be achieved, wherein the thermal emitter 1 can be operated at relatively high operating temperatures due to his specific setup.

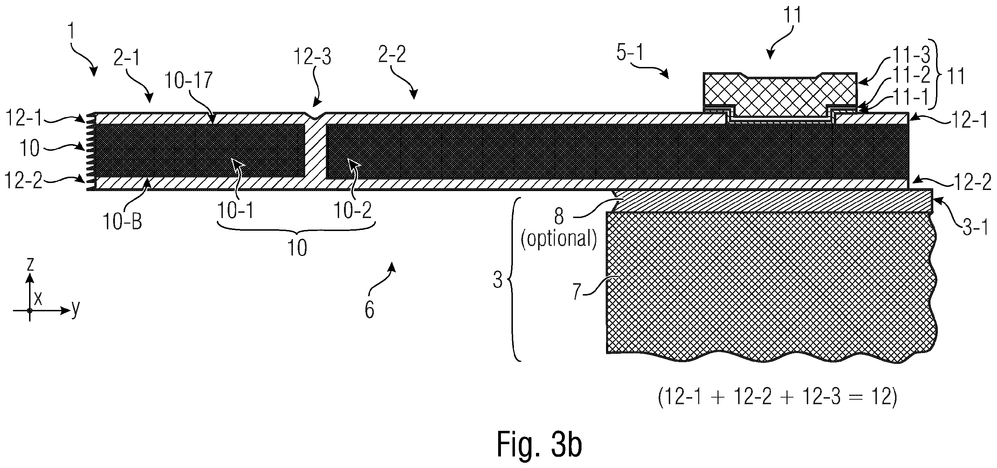

According to an embodiment, the freestanding membrane 2 of the thermal emitter 1 may extend as a layer stack parallel to a main surface region 3-1 of the substrate 3, wherein the layer stack may comprise a conducting semiconductor layer which is encapsulated in an insulating layer having the insulating material (see also Figs. 3b, 4b, 5b, for example). In other words, the layer stack forming the conductive intermediate section 2-2 parallel to the main surface region 3-1 of the substrate 3 may comprise a plurality of layers, for example, at least two layers. The conductive intermediate section 2-2 may comprise an electrically conducting semiconductor layer which is encapsulated in the insulating layer in form of an insulating encapsulation layer, wherein the electrically conducting semiconductor layer provides a current path, which is heated up to the operating temperature, during an electrical activation of the thermal emitter 1, and wherein the insulating encapsulation layer provides electrical insulation to the adjacent environment and elements and provides a high thermal conductivity for the heat generated by the conducting semiconductor layer to the environment.

According to the invention, the conductive intermediate section 2-2 forms a branched current path separated by the center section 2-1. As exemplarily shown in Fig. 1a, the conductive intermediate section 2-2 may form a ring-shaped heating element, that produces during an activated state (= electrical energization of the intermediate section 2-2) heat that may also spread into/through the center section 2-1. Thus, the center section 2-1 and the intermediate section 2-2 may together form a resulting heating structure or heating element for emitting or dissipating heat in form of thermal (e.g. infrared) radiation, e.g. into a measurement cavity. Thus, the heated ring-shaped conductive intermediate section 2-2 may provide for a relatively uniform temperature profile in the heating structure.

According to a further embodiment, the conductive intermediate section 2-2 may also comprise one of a circle, square, oval and ellipse shape (or any convex polygon shape), wherein this list of shapes of the conductive intermediate section 2-2 is not to be regarded as exhaustive.

According to an embodiment, the conducting semiconductor layer is for the most part (e.g. at least 80, 90 or 95%) or completely encapsulated (= hermetically sealed or passivated) in the insulating material for preventing an oxidation of the conducting semiconductor layer during an activated state.

According to an embodiment, the conductive intermediate section 2-2 of the freestanding membrane 2 comprises a heavily doped semiconductor layer 10 which is encapsulated in the insulating material. The heavily doped semiconductor layer may comprise a doping concentration in the range between 10¹⁸ and 10²⁰ doping atoms/cm³ for achieving the electrical conductivity of the material of the heavily doped semiconductor layer of the conductive intermediate section 2-2 in a range between 10 and 1000 S/m. The doping concentration may be chosen to achieve an electrical conductivity of the material of the heavily doped semiconductor (e.g. Si) layer in the range between 250 and 350 S/m and (about) 300 S/m in a cold (= inactivated) state and in the range between 80 and 120 S/m and (about) 100 S/m in a hot (= activated) state of the conductive intermediate section 2-2 of the freestanding membrane 2.

Based on the resulting (e.g. uniformly distributed) electrical conductivity of the material of the heavily doped semiconductor layer of the conductive intermediate section 2-2, an uniform current distribution and, accordingly, an uniform heat distribution resulting in an uniform heat dissipation can be achieved in the conductive intermediate section 2-2.

According to an embodiment, the conductive semiconductor material of the conductive intermediate section 2-2 may comprise poly-silicon or monocrystalline silicon, and the insulating material may comprise silicon nitride. Further materials may be used. To be more specific, the insulating material may comprise, for example, silicon nitride (SiₓN_{y}), silicon oxide (SiO₂), silicon oxynitride (Si₂N₂O), plastic (e.g. polymers) or ceramic, e.g. Al₂O₃ for an operation under harsh conditions. However, this list of insulating materials for covering the conducting semiconductor layer is not to be regarded as exhaustive. The conductive semiconductor material may comprise, for example, silicon (Si), such as poly-silicon (poly-Si), amorphous silicon (a-Si), or monocrystalline silicon, gallium nitride (GaN), gallium arsenide (GaAs) or aluminum nitride (AIN). However, this list of materials for the conducting semiconductor layer is not to be regarded as exhaustive.

According to an embodiment, the conductive intermediate section 2-2 of the freestanding membrane extends between at least two edge regions 5-1, 5-2 ... 5-n of the freestanding membrane 2. As shown in Fig. 1a, the laterally opposing edge regions 5-1, 5-2 may traverse or bridge the border section 2-3 to reach a respective wiring structure or contact pad 11. The wiring structure 11 may be arranged to provide a bonding area for an external electrical connection, e.g. by means of bond wires, to a control and/or supply unit. The wiring structure 11 may comprise a copper, aluminum, tungsten, gold, platinum and/or titanium material or a layered stack of at least two of these materials for providing a low contact resistance.

According to a further embodiment, the conductive intermediate section 2-2 may comprise n conductor arms or extensions 2-2-n, with n is an integer and n ≥ 2, between the at least two edge regions 5-1, 5-2 ... 5-n of the freestanding membrane 2. Thus, a Y-shaped conductive intermediate section 2-2 has n = 3 arms (e.g. two input arms and one output arm or vice versa), a X-shaped conductive intermediate section 2-2 has n = 4 arms (e.g. two input arms and two output arm or vice versa), etc., for example. The plurality of arms 2-2-n of the conductive intermediate section (2-2) and the associated edge regions 5-n of the freestanding membrane 2 may be arranged symmetrically with respect to a center or symmetry line, e.g. AA or BB, through the center point of the center section 2-1. The plurality of arms 2-2-n and the edge regions 5-n may be arranged with an angular offset or difference C, with C = 360°/n.

According to an embodiment, the perforation 4 in the border region 2-3 forms a ventilation hole or a plurality of ventilation holes in the freestanding membrane. The perforation 4 forms a ventilation path through the border section 2-3. The ventilation hole(s) of the perforation 4 allows a gas or fluid ventilation between the environmental atmospheres at both sides (i.e. adjacent to the main surface regions 2-A, 2-B) of the freestanding membrane 2. Thus, an atmospheric pressure difference between the environmental atmospheres at both sides of the freestanding membrane 2 can be leveled out or balanced.

Moreover, the ventilation holes of the perforation 4 together with the insulation material 12 of the border section 2-3 allow a thermal isolation or thermal decoupling of the heating structure, i.e. of the intermediate section 2-2 and the adjacent center section 2-1, of the freestanding membrane 2 from the substrate 2 (= bulk-Si) avoiding the substrate 2 to act as a heat sink. The ventilation and thermal isolation functionality of the border section 2-3 of the freestanding membrane 2 is very effective, as the freestanding membrane 2 may be arranged on a cavity in the substrate 3, i.e. the freestanding membrane 2 may span a cavity in the substrate 3 (see Fig. 2).

According to the invention, the center section 2-1 of the freestanding membrane is a heat spreader structure having a highly thermal conductive material with a thermal conductivity κ ≥ 30 W/m*K, e.g. at 298°C.

In case, the center section 2-1 is sufficiently thermally coupled to the intermediate section 2-2, a highly thermal conductive material of the center section 2-1 allows a nearly uniform heat distribution in the center section 2-1 and, thus, a nearly uniform heat dissipation of the conductive intermediate section 2-2 together with the center section 2-1 during an activated state (= electrical energization of the intermediate section 2-2), wherein the achieved temperature (heat) only slightly decreases in the center section 2-1. The center section 2-1 may comprise a semiconductor material, e.g. silicon, or a metal. For example, bulk-silicon has a thermal conductivity of κ ≥ 148 W/m*K at 298°C, poly-silicon has a thermal conductivity of κ ≥ 30 W/m*K at 298°C, aluminum has a thermal conductivity of κ ≥ 237 W/m*K at 293°C, copper has a thermal conductivity of κ ≥ 401 W/m*K at 293°C, gold has a thermal conductivity of κ ≥ 315 W/m*K at 300°C, and tungsten has a thermal conductivity of κ ≥ 173 W/m*K at 293°C,.

Typically, the heat spreader structure 2-1 has a disc-shaped or a square-shaped form.

However, other structures, e.g. with a perforation or recess, are possible. The shape of the heat spreader structure 2-1 may generally depend on the shape of the membrane itself. Thus, as the equi-temperature lines (= same radius) may be adapted to have the same thermal boundary conditions arising from the membrane clamping, disc-shaped membranes may be used, which have no edges with different thermal boundary conditions.

Moreover, the outer circumferential shape (contour) of the heat spreader structure 2-1 is usually adapted to the inner circumferential shape of the conductive intermediate section 2-2, wherein both elements are arranged in a minimal lateral distance (e.g. 1 to 5 µm) to achieve the close thermal coupling therebetween. The heat spreader structure 2-1 and the conductive intermediate section 2-2 are usually separated by an insulating segmentation, which may comprise a dielectric material.

According to an embodiment, the thermal emitter forms a MEMS IR emitter having an operating temperature in the range between 800 to 1100°C.

According to an embodiment, the thermal emitter 1 may be implemented by a layer stack of a surface micro-machined IR emitter (MEMS emitter) with a freestanding membrane 2 and an encapsulation (= passivation), e.g. a SiₓN_{y} layer, to prevent oxidation of the conductive intermediate section 2-2 with the heating layer having a poly-silicon or a monocrystalline silicon material. A possible material for the conductive intermediate section 2-2 is heavily-doped (poly-)silicon, which allows to operate the thermal emitter 1 at high temperatures, e. g. ~1000°C, wherein the radiated output "Pₒᵤₜ" (= emitted power) of the thermal emitter 1 depends on the generated temperature "T" in the conductive intermediate section 2-2 and the heat spreader structure 2-1 by the power of 4: ${P}_{out} ≅ {T}^{4}$

Based on the described construction of the thermal emitter 1, e.g. based on MEMS technology, such a radiation source, e.g. for a gas sensor, can provide from the system side a number of requirements, such as a small and compact size, low cost, high radiation output, high energy efficiency, high switching speed, high lifetime and bandwidth. The thermal emitter 1 may be arranged with a silicon microphone technology, so that such a thermal emitter system may have very low thermal mass due to a reduced thickness of the conductive intermediate section 2-2. This also results in a high thermal resistance. As the thermal emitter 1 has a relatively high thermal resistance (= low thermal mass) a relatively high energy efficiency (= high temperature increase per Watt input power) and a high switching speed can be achieved, wherein the thermal emitter 1 can be operated at relatively high operating temperatures due to his specific setup.

Using poly-Si as the heater material, the reliability at high operating temperatures can be increased, wherein the thermal emitter 1, i.e. the conductive intermediate section 2-2, may be less prone to the electromigration effect compared to metal.

Further, Fig. 1a shows some exemplary lateral dimensions of the different elements of the freestanding membrane 2 parallel to the x-axis. The center section 2-1 may comprise a lateral width (diameter) w₂₋₁ between 100 and 1600 µm, between 200 and 800 µm or between 300 and 600 µm, or of about 400 µm +/- 40 µm. The conductive intermediate section 2-2 may comprise a lateral width w₂₋₂ between 25 and 400 µm, between 50 and 200 µm or between 75 and 125 µm, or of about 100 µm +/- 10 µm. The border section 2-3 may comprise a lateral width w₂₋₃ between 25 and 400 µm, between 50 and 200 µm or between 75 and 125 µm, or of about 100 µm +/- 10 µm.

According to an embodiment, the border section 2-3 of the freestanding membrane 2 may comprise a semiconductor layer encapsulated in an insulating material or comprises an insulating material layer. According to an embodiment, the center section 2-1 of the freestanding membrane 2 may comprise a semiconductor layer encapsulated in an insulating material or comprises an insulating material layer.

According to an embodiment, the thermal emitter 1 may further comprise a plasmonic structure on the center section 2-1 and the conductive intermediate section 2-2 of the freestanding membrane 2, wherein the plasmonic structure is at least partially encapsulated in the insulating material, and wherein the plasmonic structure forms a bandpass filter for an IR radiation emitted by the freestanding membrane during an operation of the thermal emitter. According to an embodiment, the plasmonic structure may form a plasmonic resonator for the emitted IR radiation.

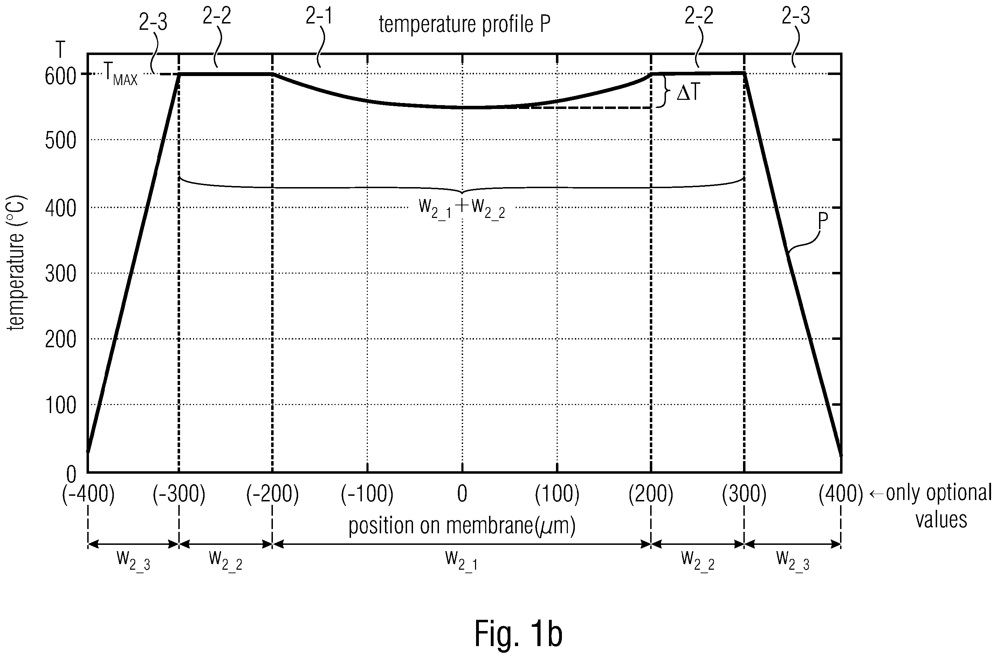

Fig. 1b shows a schematic (lateral) temperature profile of the freestanding membrane 2 of the thermal emitter 1 according to an embodiment. In Fig. 1b an exemplary temperature profile P belongs to the thermal emitter 1 of Fig. 1a and is associated to the different sections of the freestanding membrane 2 of the thermal emitter 1 during an activated state (= electrical energization of the intermediate section 2-2).

The depicted temperature profile P shows the temperature T(°C = y-axis) as a function of a distance (x-axis) from the center of the freestanding membrane 2. Accordingly, the temperature profile P may indicate a heat distribution depending on a lateral distance from the conductive intermediate section 2-2.

As shown in Fig. 1b, the temperature profile P stems from the ring-shaped conductive intermediate section 2-2 (= heating element). The highest temperature T_{MAX} may be reached at the ring portion of the heating element 2-2 while the temperature T may slightly decrease by ΔT towards the center portion of the freestanding membrane 2, i.e. inside the disc-shaped center section 2-1. In the center section 2-1, the temperature T lies within a temperature range ΔT, wherein ΔT depends on the thermal conductivity of the material of the center section 2-1, i.e. the higher is the thermal conductivity of the material of the center section 2-1 the smaller is ΔT. Based on the construction of the thermal emitter 1, the temperature decrease ΔT may be less than 15, 10 or 5% of the temperature T_{MAX} at the ring portion of the heating element 2-2. Furthermore, the temperature T may rapidly drop with decreasing lateral distance from the ring-shaped conductive intermediate section 2-2 towards the peripheral portions of the freestanding membrane 2, i.e. in the border section 2-3.

The thermal isolation functionality of the border section 2-3 of the freestanding membrane 2 allows, to a large extent, a thermal decoupling of the intermediate section 2-2 of the freestanding membrane 2 from the substrate 2 (e.g. bulk-Si) which results in the rapid drop of the temperature T in the border section 2-3 having the perforation 4 in the insulation material 12.

At the time of activation of the intermediate section 2-2 of the thermal emitter 1, heat (increased temperature T) is produce in the intermediate section 2-2 and spreads into the thermally conductive center section 2-1. This heat (about T_{MAX}) may be emitted or dissipated by the conductive intermediate section 2-2 and the center section 2-1 in form of thermal (e.g. infrared) radiation.

Fig. 2 shows a schematic bottom 3D view of the thermal emitter 1. According to an embodiment the center section 2-1, the intermediate section 2-2 and at least partially the border section 2-3 of the freestanding membrane 2 may be arranged on a cavity or recess 6 in the substrate 3. Further, the freestanding membrane 2 may cover the cavity 6 in the substrate 3, wherein the border section 2-3 of the freestanding membrane 2 is attached to the substrate 3. The substrate 3 may, for example, comprise the bulk semiconductor substrate 7, e.g. bulk-Si.

In the following, a number of different possible implementations of the thermal emitter 1 are exemplarily described. In the present description of embodiments, the same or similar elements having the same structure and/or function are provided with the same reference numbers or the same name, wherein a detailed description of such elements will not be repeated for every embodiment. Thus, the above description with respect to Figs. 1a-b and 2 and is equally applicable to the further embodiments as described below. In the following description, essentially the differences, e.g. additional elements, to the embodiment as shown above and the technical effect(s) resulting therefrom are discussed in detail.

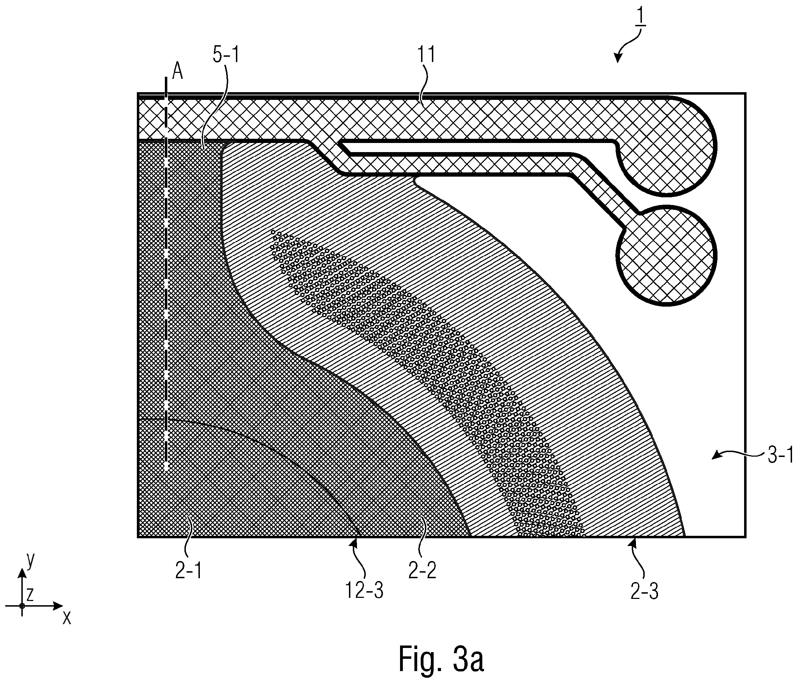

Fig. 3a shows a schematic top partial view of a thermal emitter 1, wherein Fig. 3b shows a schematic cross-sectional partial view of a thermal emitter 1 along a dashed intersection line A of the thermal emitter of Fig. 3a. The intersection line A is parallel to the y-axis.

According to an embodiment of the thermal emitter 1, the center section 2-1 of the freestanding membrane 2 may comprise a first portion 10-1 of the semiconductor layer 10 encapsulated in an insulating material 12. Moreover, the conductive intermediate section 2-2 of the freestanding membrane 2 may comprise a second portion 10-2 of semiconductor layer 10 encapsulated in an insulating material 12. The insulating material 12 may comprise a first and a second insulating material layer 12-1, 12-2, wherein the first insulating material layer 12-1 is arranged on the first main surface region 10-A of the semiconductor layer 10, wherein the second insulating material layer 12-2 is arranged on the second main surface region 10-B of the semiconductor layer 10, and wherein a dielectric segmentation line 12-3 of the insulating material 12 is arranged laterally between the first and second portion 10-1, 10-2 of the semiconductor layer 10 for electrically separating the two portions.

Moreover, the border section 2-3 of the freestanding membrane 2 may comprise a third portion 10-3 of semiconductor layer 10 encapsulated in the insulating material 12 or may comprise an insulating material layer 12-2. Optionally, a further dielectric segmentation line 12-3 of the insulating material 12 may arranged laterally between the second portion and third 10-2, 10-3 of the semiconductor layer 10 for electrically separating the two portions (in case, the third portion 10-3 is present).

At least the second portion 10-2 of semiconductor layer 10 is heavily doped. Optionally, the first and third (optional) portions 10-1, 10-3 of semiconductor layer 10 are also heavily doped.

Thus, the freestanding membrane 2 of the thermal emitter 1 may extend as a layer stack comprising the (portions 10-1, 10-2 and optional 10-3 of the) semiconductor layer 10 between the first and a second insulating material layer 12-1, 12-2 of the insulating material 12.

The insulating material 12 may form a passivation of the (portions 10-1 and/or 10-2 of the) semiconductor layer 10 (= the heating element) of the freestanding membrane 2. The heating element itself might be integrated into the freestanding membrane (= carrier membrane) 2 resulting in improved thermal properties of the thermal heater 1.

As shown in Fig. 3a-b, the wiring structure 11 is arranged at the edge region 5-1 of the freestanding membrane 2 to provide a bonding area for an external electrical connection, e.g. by means of bond wires, to a control and/or supply unit, for example. The wiring structure 11 may comprise a gold, platinum and/or titanium material or a layered stack of at least two of these materials for providing a low contact resistance. As exemplarily shown in Fig. 3b, the wiring structure 11 may comprise a metal layer stack comprising a Ti layer 11-1 on the second portion 10-2 of semiconductor layer 10 of the conductive intermediate section 2-2, a Pt layer 11-2 on the Ti layer 11-1, and an Au layer 11-3 on the Pt layer 11-2.

As the center section 2-1 is thermally coupled to the intermediate section 2-2, a highly thermal conductive material of the center section 2-1 allows a nearly uniform heat distribution in the center section 2-1 and, thus, a nearly uniform heat dissipation of the conductive intermediate section 2-2 together with the center section 2-1 during an activated state (= electrical energization of the intermediate section 2-2),

As shown in Fig. 3a-b, the substrate 3 may comprise a bulk semiconductor substrate 7 and an optional insulating layer 8 to which the freestanding membrane 2 is mechanically attached. According to a further embodiment, the optional insulating layer 8 may be omitted, wherein the second insulating material layer 12-2 of the freestanding membrane may also be directly connected to the semiconductor substrate 7.

As shown in Fig. 3a-b, the semiconductor layer 10 (and it's portions 10-1, 10-2, optional 10-3) may comprise a (vertical) thickness d₁₀ between 200 and 2000 nm, between 400 and 1300 nm or between 500 and 800 nm, or of about 660 nm +/- 60 nm (= between 600 and 720 nm). Alternatively, the semiconductor layer 10 may comprise a (vertical) thickness d₁₀ between 80 and 1200 nm, between 160 and 700 nm or between 250 and 400 nm, or of about 330 nm +/- 30 nm (= between 300 and 360 nm).

The insulating material layers 12-1, 12-2 may each comprise a (vertical) thickness d₁₂ between 50 and 400 nm, between 100 and 300 nm or between 120 and 160 nm, or of about 140 nm +/- 10 nm (= between 130 and 150 nm).

The insulating layer 8 may comprise a (vertical) thickness d₈ between 500 and 8000 nm, between 1000 and 4000 nm or between 1800 and 2600 nm, or of about 2200 nm +/- 200 nm (= between 2000 and 2400 µm).

The bulk substrate 7 each comprise a (vertical) thickness d₇ between 50 and 1000 µm, between 100 and 750 µm or between 200 and 300 µm, or of about 250 µm +/- 25 µm (= between 225 and 275 µm).

Contact pad 11 may comprise a metal layer stack having the Ti layer 11-1 with a (vertical) thickness d₁₁₋₁ of about 400 nm +/- 40 nm, the Pt layer 11-2 with a (vertical) thickness d₁₁₋₂ of about 100 nm +/- 10 nm, and the Au layer 11-3 with a (vertical) thickness d₁₁₋₃ of about 50 nm +/- 5 nm.

The above values and/or value ranges are equally applicable to the further embodiments described herein.

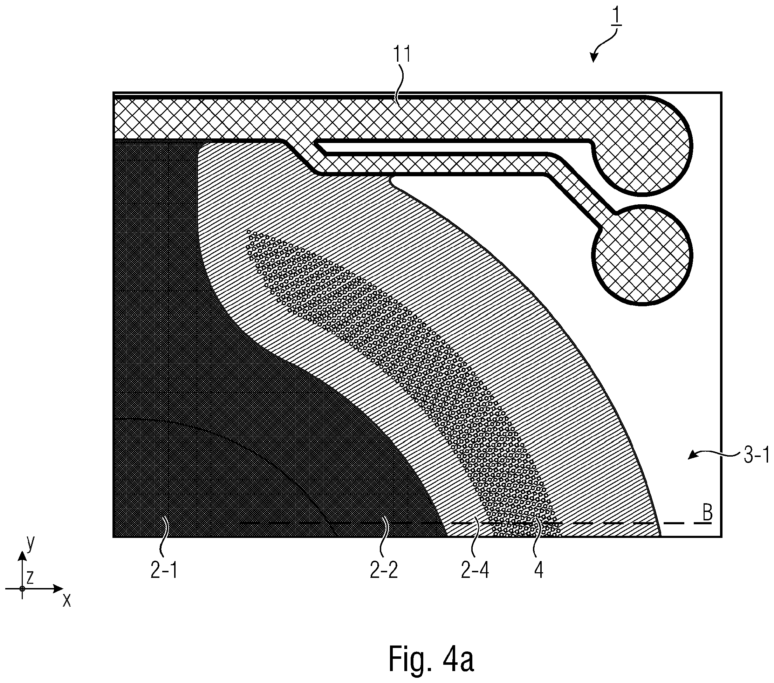

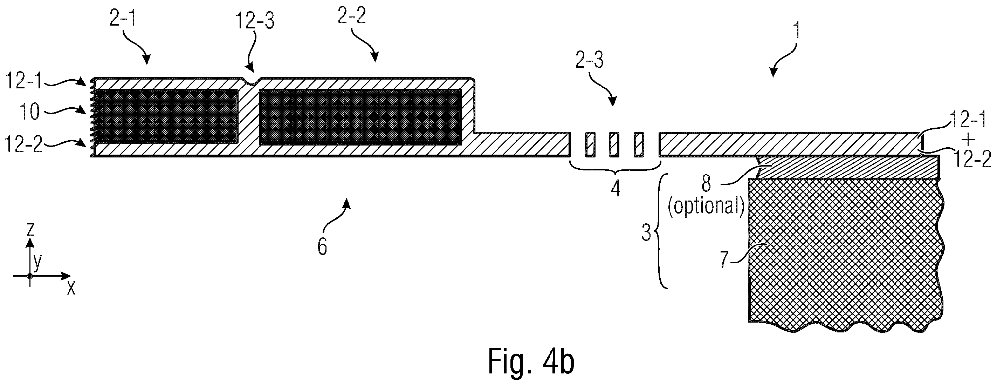

Fig. 4a shows a schematic top partial view of a thermal emitter 1, wherein Fig. 4b shows a schematic cross-sectional partial view of a thermal emitter 1 along a dashed intersection line B of the thermal emitter of Fig. 4a. The intersection line A is parallel to the x-axis.

As shown in Figs. 4a-b, the border section 2-3 of the freestanding membrane 2 may comprise the combined insulating material layers 12-1 and 12-2 having the perforation 4 for providing the ventilation and thermal isolation functionality.

As shown in Fig. 4a-b, the substrate 3 may comprise a bulk semiconductor substrate 7 and an optional insulating layer 8 to which the freestanding membrane 2 is mechanically attached. According to a further embodiment, the optional insulating layer 8 may be omitted, wherein the second insulating material layer 12-2 of the freestanding membrane may also be directly connected to the semiconductor substrate 7. Thus, the border section 2-3 of the freestanding membrane 2 may only comprise the insulating material 12, e.g. the insulating material layers 12-1 and 12-2.

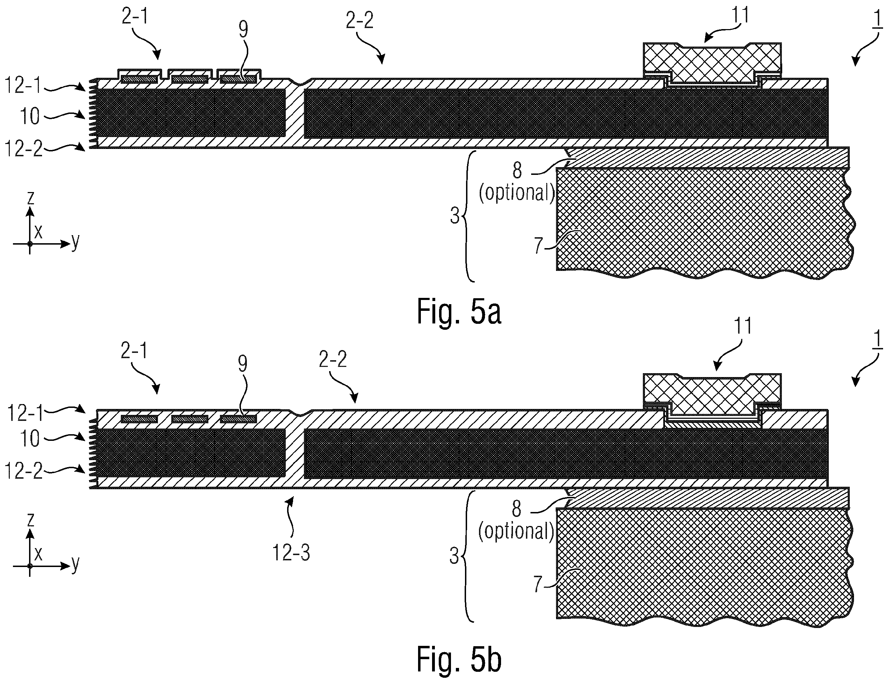

Fig. 5a shows a schematic cross-sectional partial view of a thermal emitter 1 with fully embedded plasmonic structures 9. The arrangement of the thermal emitter 1 of Fig. 5a differs from the arrangement of the thermal emitter 1 of Fig. 3b in that the thermal emitter 1 comprises a plasmonic structure 9 on the center section 2-1 and/or optionally on the conductive intermediate section 2-2 of the freestanding membrane 2, wherein the plasmonic structure 9 is completely encapsulated or enclosed in the insulating material 12, e.g. in the first insulating material layer 12-1. According to an embodiment, the plasmonic structure 9 may form a bandpass filter or a plasmonic resonator for the IR radiation emitted by the freestanding membrane 2 during operation of the thermal emitter 1.

The plasmonic structure 9 may comprise plasmonic materials (metals or metal-like materials or dielectric materials) that exhibit negative real permittivity, for example, gold, silver or silicon.

The thermal emitter 1 may emit light as a black body emitter with a broad emission spectrum, for example, between 0.25 µm and 3 µm. Including plasmonic structures 9, for example, at the heating element (= the center section 2-1 and/or the conductive intermediate section 2-2 of the freestanding membrane 2) may provide an enhancement of the radiation in a desired range of wavelengths. Accordingly, the thermal emitter 1 may be configured to emit thermal radiation, e.g. infrared radiation, in a predetermined wavelength spectrum, e.g. into a measurement cavity of a gas sensor or a fluid sensor. The particular wavelength of the emitted thermal radiation may depend on the gas or fluid to be detected, i.e. the so-called analyte or target gas/fluid.

With the embedding of the plasmonic structure 9 in the insulating material 12, the desorption, the loss of adhesion or the diffusion/alloying of the material of the plasmonic structure 9 into the base material can be prevented. The thermal emitter 1 (heating structure) may be provided with an enhanced emission in the desired range of wavelengths, wherein a long term stability, a long live time, a high efficiency and small chip sizes can be realized.

Fig. 5b shows a schematic cross-sectional partial view of a thermal emitter with partially embedded plasmonic structures. The arrangement of the thermal emitter 1 of Fig. 5b differs from the arrangement of the thermal emitter 1 of Fig. 5a in that the thermal emitter 1 comprises a plasmonic structure 9 on the center section 2-1 and/or optionally on the conductive intermediate section 2-2 of the freestanding membrane 2, wherein the plasmonic structure 9 is partially encapsulated or enclosed in the insulating material 12.

As shown in Fig. 5b, the plasmonic structure 9 may be arranged directly on the center section 2-1 and/or optionally on the conductive intermediate section 2-2 of the freestanding membrane 2. Thus, the plasmonic structure 9 is encapsulated between the insulating material 12 and the respective portion 10-1 and/or 10-2 of the semiconductor layer 10.

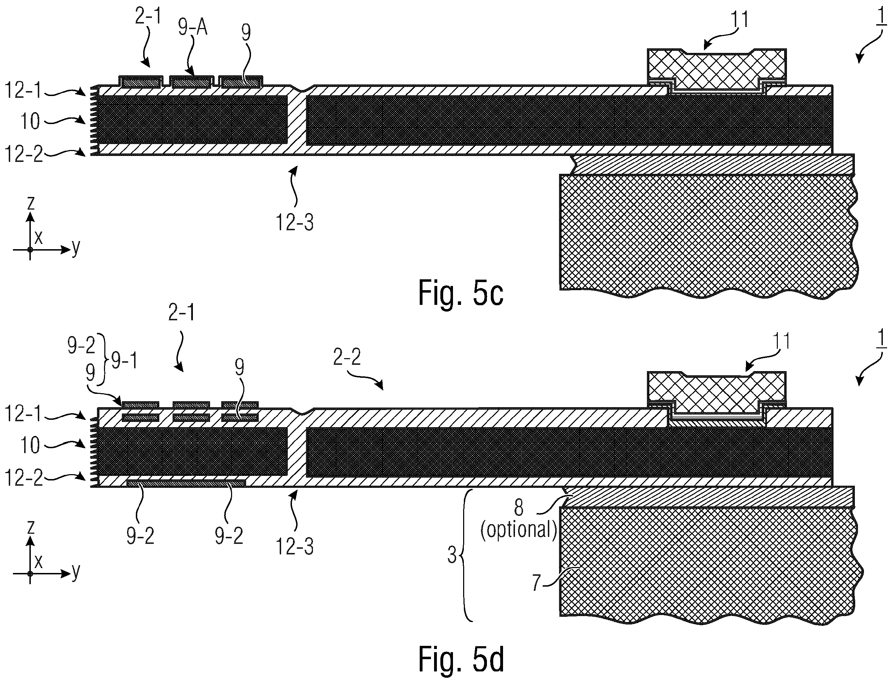

Fig. 5c shows a schematic cross-sectional partial view of a thermal emitter with at least partially exposed plasmonic structures 9 according to an embodiment. The arrangement of the thermal emitter 1 of Fig. 5c differs from the arrangement of the thermal emitter 1 of Fig. 5a-b in that the thermal emitter 1 comprises a plasmonic structure 9 on the center section 2-1 and/or optionally on the conductive intermediate section 2-2 of the freestanding membrane 2, wherein the plasmonic structure 9 is arranged on the first insulating material layer 12-1 of the insulating material 12 and the far side main surface region 9-A (= averted to the layer 12-1) is at least partially or completely exposed to the environment.

Fig. 5d shows a schematic cross-sectional partial view of a thermal emitter 1 with a plasmonic resonator 9-1 according to a further embodiment. The thermal emitter 1 may comprise a plasmonic structure 9 neighboring to the first main surface region 10-A of the semiconductor layer 10, as shown in any of Figs. 5a-c, wherein a reflective layer 9-2 is arranged on the opposite side of the semiconductor layer 10, i.e. neighboring to the second main surface region 10-B of the semiconductor layer 10. The reflective layer 9-2 may comprise a reflective material (e.g. metal) on the bottom side of the membrane 2. A reflective material for plasmonics is typically a low-Ohmic material.

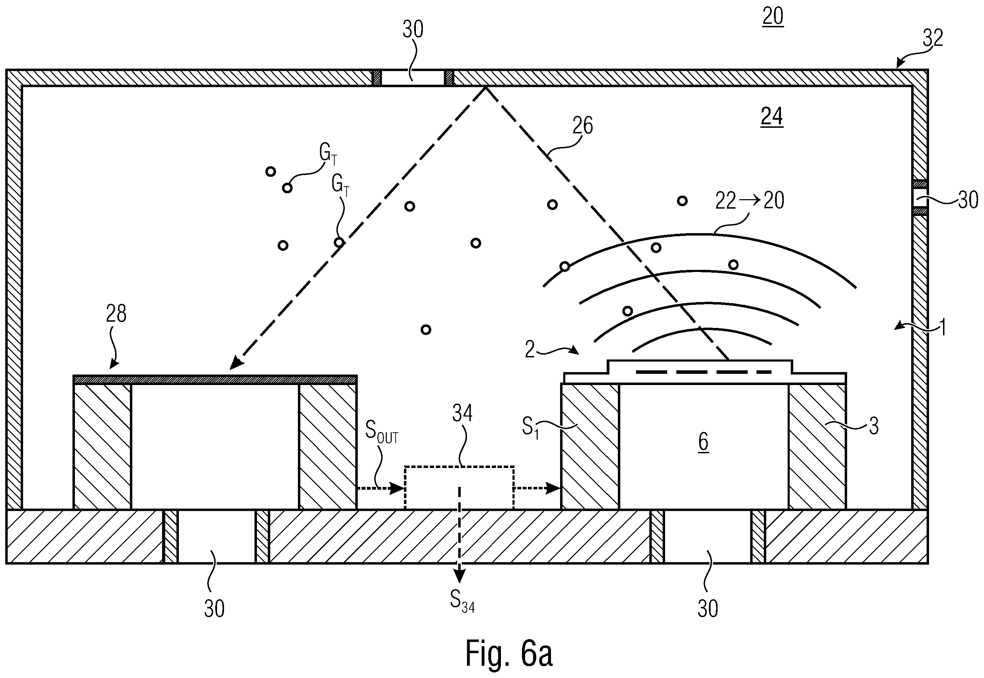

Fig. 6a shows a schematic cross-sectional view of a MEMS gas sensor or MEMS fluid sensor 20 according to an embodiment. The above evaluations, which relate to the thermal emitter 1, are equally applicable to the thermal emitter (= radiation source) 1 of Fig. 6a. In the present context, embodiments may relate to the detection and sensing of a gas or a gas component, which may be present in an environmental atmosphere, for example. However, the present concept is generally applicable to the detection and sensing of a fluid or a fluid component, wherein the term fluid may generally relate to a liquid or a gas. In case, the environmental medium relates to environmental air, the target fluid may relate to a target gas or target gas component which is present in the environmental air (= environmental atmosphere). The present concept is equally applicable to sensing a target liquid or a target liquid component in the environmental medium, an environmental gas or environmental liquid.

According to an embodiment, the MEMS gas sensor 20 may be arranged as a PAS sensor (PAS = = photoacoustic spectroscopy) may comprise the thermal emitter 1 for emitting thermal radiation 22 and may comprise a measurement volume 24 having a target gas G_{T} and providing an optical interaction path 26 for the emitted thermal radiation 22, and may comprise an acoustic transducer 28 or a thermal detector for providing a detector output signal S_{OUT} based on the optical interaction of the emitted thermal radiation 22 with the target gas G_{T} in the measurement volume . As shown in Fig. 6a, the thermal emitter 1 and the acoustic transducer 28 are arranged inside a mutual measurement volume (= cavity) 24.

The photoacoustic principle offers a very high selectivity together with a relatively inexpensive set of components, for example the (infrared) emitter 1, an optional filter 9 and the detector 28. The PAS-principle shows, for example, a good sensitivity to carbon dioxide as target gas.

The cavity 24 is arranged for providing an optical interaction path 26 for an interaction of the thermal radiation 22 having a center wavelength λ₀ with a target gas G_{T} in the cavity 24, wherein the cavity 24 is accessible, e.g. through at least one access opening 30 in a housing 32, for an environmental gas comprising the target gas component. The gas sensor 20 may be formed as a MEMS gas sensor (MEMS = micro-electromechanical system) in a PAS configuration. The cavity 24 may be formed as a waveguide or a reflecting housing 36, wherein reflective coatings such as metal layers on shaped structural housing walls (= cavity walls) may guide the emitted radiation thorough the interaction path by means of reflections. As shown in Fig. 6a, the cavity 24 is formed by the housing 32.

The particular wavelength of the emitted radiation 22 may be set to the respective gas or gas composition to be detected, i.e. the so-called analytic or target gas G_{T}. The emitter structure 1 may be configured to intermittently or periodically emit the thermal radiation 22. Accordingly, the environmental gas inside the measurement cavity 24, including the target gas, absorbs the intermittently emitted thermal radiation and, in consequence, the gases intermittently or periodically heats up and cools down in reaction to the emitted thermal radiation. The absorption and related heating and cooling of the gas inside the measurement cavity 24 may produce an alternating increase and decrease of pressure inside the cavity 24. These pressure variations may be detected by the acoustic transducer 28, for example a MEMS microphone. The amount of absorption of the emitted thermal radiation by the gases and the related pressure variations inside the cavity 24 may depend on the sort of gas inside the cavity 24 and it may vary with the respective target gas G_{T} and its concentration. Each target gas G_{T} may comprise a characteristic absorption spectrum, i.e. it may cause characteristic pressure variations in response to the emitted thermal radiation 22. Said characteristic absorption spectrum may also be referred to as a gas-specific fingerprint. Accordingly, the acoustic transducer 28 may record a signal that may be characteristic for the respective target gas G_{T}, such that the acoustic transducer 28 may thereby detect and identify the respective target gas G_{T}.

According to an embodiment, the gas sensor 20 may optionally comprise a processing circuit or controller 34 for providing a (e.g. time varying or pulsed) excitation signal S₁ to the IR emitter 1 and for reading out and, optionally, processing the respective output signal S_{OUT} of the acoustic transducer 28 and for providing a gas sensor output signal S₃₄ having an information on the concentration of the target gas component G_{T} in the environmental gas in the cavity 24. The processing circuit 34 may be formed by an ASIC (ASIC = application specific integrated circuit).

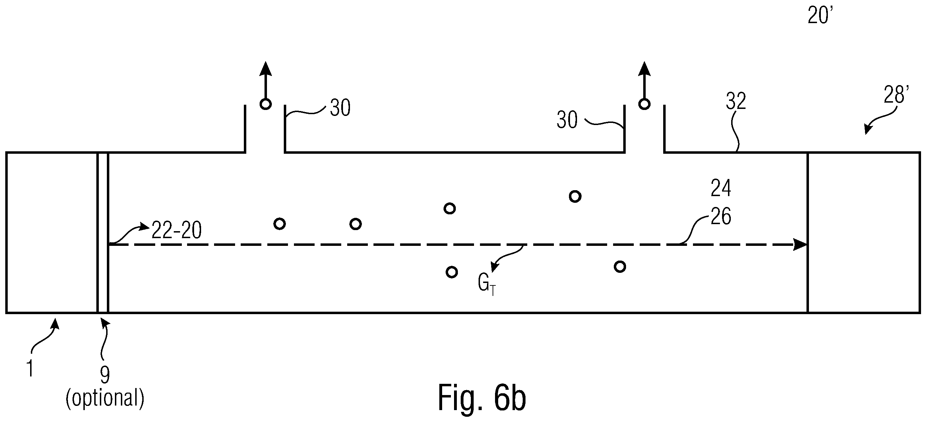

Fig. 6b shows a schematic cross-sectional view of a further example of a gas sensor or fluid sensor 20' according to an embodiment. The above evaluations, which relate to the thermal emitter 1, are equally applicable to the thermal emitter (= radiation source) 1 of Fig. 6b.

According to an embodiment, the MEMS gas sensor 20' may be arranged as a NDIR sensor (NDIR = nondispersive infrared). The MEMS gas sensor 20' may comprise the thermal emitter 1 for emitting thermal radiation 22 and may comprise a measurement volume 24 having a target gas G_{T} and providing an optical interaction path 26 for the emitted thermal radiation 22, and may comprise a (direct) thermal detector 28' for providing a detector output signal S_{OUT} based on the optical interaction of the emitted thermal radiation 22 with the target gas G_{T} in the measurement volume. As shown in Fig. 6b, the thermal emitter 1 and the detector 28 may be arranged outside the cavity 24.

The NDIR gas sensor 20' specifically measures the abundance, or concentration, of target gases G_{T} in the sample chamber 24. If there are gases in the interaction path 26 from the infrared light source 1 to a detector 28' then, in the non-dispersive system, the IR radiation 22 is absorbed by the target gas(es), if the IR radiation 22 having a center wavelength λ₀ falls in the absorption spectrum of the target gas G_{T}. The degree of absorption depends on or is a measure of the concentration of a target gas G_{T} in an environmental gas.

The cavity 24 may be formed as a waveguide or a reflecting housing 32, wherein reflective coatings such as metal layers on shaped structural housing walls (= cavity walls) may guide the emitted radiation thorough the interaction path by means of reflections. The cavity 24 is accessible, e.g. through at least one access opening 30 in a housing 32 for an environmental gas comprising the target gas component

Although specific embodiments have been illustrated and described herein, it will be appreciated by those of ordinary skill in the art that a variety of alternate and/or equivalent implementations may be substituted for the specific embodiments shown and described without departing from the scope of the present embodiments. This application is intended to cover any adaptations or variations of the specific embodiments discussed herein. Therefore, it is intended that the embodiments be limited only by the appended claims.

## Claims

1. A thermal emitter (1) comprising:
a freestanding membrane (2) supported by a substrate (3), wherein the freestanding membrane (2) comprises in a lateral extension a center section (2-1), an electrically conductive intermediate section (2-2) and a border section (2-3), wherein the electrically conductive intermediate section (2-2) laterally surrounds the center section (2-1), wherein the electrically conductive intermediate section (2-2) is electrically isolated from the center section (2-1) and is thermally coupled to the center section (2-1), wherein the electrically conductive intermediate section (2-2) comprises a plurality of layers in which an electrically conductive semiconductor layer (10-2) is passivated in an insulating material (12), and wherein the electrically conductive intermediate section (2-2) forms a branched current path separated by the center section (2-1) and forms a heating element which produces heat during an activated state, the heat spreading in the center section (2-1), wherein the center section (2-1) is a heat spreader structure having a highly thermal conductive material with a thermal conductivity κ ≥ 30 W/m*K at 298°C, and
wherein the border section (2-3) at least partially surrounds the electrically conductive intermediate section (2-2) and is electrically isolated from the electrically conductive intermediate section (2-2), wherein a perforation (4) is formed through the border section (2-3).

2. The thermal emitter of claim 1, wherein the freestanding membrane (2) extends as a layer stack parallel to a main surface region (3-1) of the substrate (3).

3. The thermal emitter of any of the preceding claims, wherein the conductive semiconductor layer of the conductive intermediate section (2-2) of the freestanding membrane (2) is a heavily doped semiconductor layer which is passivated in the insulating material, wherein the conductive semiconductor material comprises poly-silicon or monocrystalline silicon, and wherein the insulating material comprises silicon nitride.

4. The thermal emitter of any of the preceding claims, wherein the conductive intermediate section (2-2) of the freestanding membrane (2) extends between two laterally opposing edge regions (5-1, 5-2) of the freestanding membrane (2).

5. The thermal emitter of any of the preceding claims, wherein the conductive intermediate section (2-2) of the freestanding membrane (2) comprises a plurality of conductor arms (2-2-1, 2-2-2, ..., 2-2-n) which extend between a plurality of associated edge regions (5-1, 5-2, ..., 5-n) of the freestanding membrane (2), wherein the plurality of arms (2-2-1, 2-2-2, ..., 2-2-n) of the conductive intermediate section (2-2) and the edge regions (5-1, 5-2, ..., 5-n) of the freestanding membrane (2) are arranged symmetrically with respect to a symmetry line (AA) through the center point of the center section 2-1.

6. The thermal emitter of any of the preceding claims, wherein the center section (2-1) and the intermediate section (2-2) of the freestanding membrane (2) are arranged on a cavity (6) in the substrate (3).

7. The thermal emitter of claim 6, wherein the freestanding membrane (2) covers the cavity (6) in the substrate (3), wherein the border section (2-3) of the freestanding membrane (2) is attached to the substrate (3).

8. The thermal emitter of any of the preceding claims, wherein the substrate (3) comprises a bulk semiconductor substrate (7) and an insulating layer (8), wherein the insulating layer (8) forms a main surface region (3-1) of the substrate (3) to which the freestanding membrane (2) is attached.

9. The thermal emitter of any of the preceding claims, wherein the perforation (4) in the border section (2-3) forms a ventilation hole or a plurality of ventilation holes in the freestanding membrane (2).

10. The thermal emitter of any of the preceding claims, wherein the border section (2-3) of the freestanding membrane (2) comprises a semiconductor layer encapsulated in an insulating material or comprises an insulating material layer.

11. The thermal emitter of any of the preceding claims, wherein the center section (2-1) of the freestanding membrane (2) comprises a semiconductor layer encapsulated in an insulating material or comprises an insulating material layer.

12. The thermal emitter of any of the preceding claims, wherein the center section (2-1) of the freestanding membrane (2) is a disc-shaped heat spreader structure.

13. The thermal emitter of any of the preceding claims, further comprising a plasmonic structure (9) on the center section (2-1) and the conductive intermediate section (2-2) of the freestanding membrane (2), wherein the plasmonic structure (9) forms a bandpass filter for an IR radiation emitted by the freestanding membrane (2) during an operation of the thermal emitter.

14. The thermal emitter of claim 13, wherein the plasmonic structure (9) forms a plasmonic resonator (9-1) for the emitted IR radiation.

15. The thermal emitter of any of claims 3-14, wherein the thermal emitter forms a MEMS IR emitter having an operating temperature in the range between 800 to 1100°C.

16. A MEMS gas or fluid sensor, comprising:
a thermal emitter for emitting thermal radiation according to any of the preceding claims,
a measurement volume having a target gas or target fluid and providing an optical interaction path for the emitted thermal radiation,
and
an acoustic transducer or a direct thermal detector for providing a detector output signal based on the optical interaction of the emitted thermal radiation with the target gas or target fluid in the measurement volume.

## Patentansprüche

1. Ein thermischer Emitter (1), der folgende Merkmale aufweist:
eine freistehende Membran (2), die von einem Substrat (3) getragen wird, wobei die freistehende Membran (2) in einer lateralen Erstreckung einen Mittelabschnitt (2-1), einen elektrisch leitfähigen Zwischenabschnitt (2-2) und einen Randabschnitt (2-3) aufweist,
wobei der elektrisch leitfähige Zwischenabschnitt (2-2) den Mittelabschnitt (2-1) lateral umgibt, wobei der elektrisch leitfähige Zwischenabschnitt (2-2) von dem Mittelabschnitt (2-1) elektrisch isoliert ist und mit dem Mittelabschnitt (2-1) thermisch gekoppelt ist, wobei der elektrisch leitfähige Zwischenabschnitt (2-2) eine elektrisch leitfähige Halbleiterschicht (10-2) aufweist, die in einem Isoliermaterial (12) eingekapselt ist, das eine erste und eine zweite Isoliermaterialschicht (12-1, 12-2) aufweist, wobei das Isoliermaterial (12) ein dielektrisches Material aufweist, und wobei der elektrisch leitfähige Zwischenabschnitt (2-2) einen verzweigten Strompfad bildet, der durch den Mittelabschnitt (2-1) separiert ist, und ein Heizelement bildet, das während eines aktivierten Zustands Wärme erzeugt, wobei sich die Wärme in dem Mittelabschnitt (2-1) ausbreitet, wobei der Mittelabschnitt (2-1) eine Wärmeausbreitungsstruktur ist, die ein hochthermisch leitfähiges Material mit einer thermischen Leitfähigkeit κ ≥ 30 W/m*K bei 298 °C aufweist, und
wobei der Randabschnitt (2-3) den elektrisch leitfähigen Zwischenabschnitt (2-2) zumindest teilweise umgibt und von dem elektrisch leitfähigen Zwischenabschnitt (2-2) elektrisch isoliert ist, wobei eine Perforation (4) durch den Randabschnitt (2-3) gebildet ist.

2. Der thermische Emitter gemäß Anspruch 1, wobei sich die freistehende Membran (2) als ein Schichtstapel parallel zu einem Hauptoberflächenbereich (3-1) des Substrats (3) erstreckt.

3. Der thermische Emitter gemäß einem der vorhergehenden Ansprüche, wobei die leitfähige Halbleiterschicht des leitfähigen Zwischenabschnitts (2-2) der freistehenden Membran (2) eine stark dotierte Halbleiterschicht ist, die in dem Isoliermaterial eingekapselt ist, wobei das leitfähige Halbleitermaterial Polysilizium oder monokristallines Silizium aufweist, und wobei das Isoliermaterial Siliziumnitrid aufweist.

4. Der thermische Emitter gemäß einem der vorhergehenden Ansprüche, wobei sich der leitfähige Zwischenabschnitt (2-2) der freistehenden Membran (2) zwischen zwei lateral gegenüberliegenden Randbereichen (5-1, 5-2) der freistehenden Membran (2) erstreckt.

5. Der thermische Emitter gemäß einem der vorhergehenden Ansprüche, wobei der leitfähige Zwischenabschnitt (2-2) der freistehenden Membran (2) eine Mehrzahl von Leiterarmen (2-2-1, 2-2-2, ..., 2-2-n) aufweist, die sich zwischen einer Mehrzahl von zugeordneten Randbereichen (5-1, 5-2, ..., 5-n) der freistehenden Membran (2) erstreckt, wobei die Mehrzahl von Armen (2-2-1, 2-2-2, ..., 2-2-n) des leitfähigen Zwischenabschnitts (2-2) und die Randbereiche (5-1, 5-2, ..., 5-n) der freistehenden Membran (2) symmetrisch in Bezug auf eine Symmetrielinie (AA) durch den Mittelpunkt des Mittelabschnitts 2-1 angeordnet sind.

6. Der thermische Emitter gemäß einem der vorhergehenden Ansprüche, wobei der Mittelabschnitt (2-1) und der Zwischenabschnitt (2-2) der freistehenden Membran (2) auf einem Hohlraum (6) in dem Substrat (3) angeordnet sind.

7. Der thermische Emitter gemäß Anspruch 6, wobei die freistehende Membran (2) den Hohlraum (6) in dem Substrat (3) bedeckt, wobei der Randabschnitt (2-3) der freistehenden Membran (2) an dem Substrat (3) angebracht ist.

8. Der thermische Emitter gemäß einem der vorhergehenden Ansprüche, wobei das Substrat (3) ein Bulk-Halbleitersubstrat (7) und eine Isolierschicht (8) aufweist, wobei die Isolierschicht (8) einen Hauptoberflächenbereich (3-1) des Substrats (3) bildet, an dem die freistehende Membran (2) angebracht ist.

9. Der thermische Emitter gemäß einem der vorhergehenden Ansprüche, wobei die Perforation (4) in dem Randabschnitt (2-3) ein Belüftungsloch oder eine Mehrzahl von Belüftungslöchern in der freistehenden Membran (2) bildet.

10. Der thermische Emitter gemäß einem der vorhergehenden Ansprüche, wobei der Randabschnitt (2-3) der freistehenden Membran (2) eine Halbleiterschicht aufweist, die in einem Isoliermaterial eingekapselt ist, oder eine Isoliermaterialschicht aufweist.

11. Der thermische Emitter gemäß einem der vorhergehenden Ansprüche, wobei der Mittelabschnitt (2-1) der freistehenden Membran (2) eine Halbleiterschicht aufweist, die in einem Isoliermaterial eingekapselt ist, oder eine Isoliermaterialschicht aufweist.

12. Der thermische Emitter gemäß einem der vorhergehenden Ansprüche, wobei der Mittelabschnitt (2-1) der freistehenden Membran (2) eine scheibenförmige Wärmeausbreitungsstruktur ist.

13. Der thermische Emitter gemäß einem der vorhergehenden Ansprüche, der ferner eine plasmonische Struktur (9) auf dem Mittelabschnitt (2-1) und dem leitfähigen Zwischenabschnitt (2-2) der freistehenden Membran (2) aufweist, wobei die plasmonische Struktur (9) ein Bandpassfilter für eine IR-Strahlung bildet, die von der freistehenden Membran (2) während eines Betriebs des thermischen Emitters emittiert wird.

14. Der thermische Emitter gemäß Anspruch 13, wobei die plasmonische Struktur (9) einen plasmonischen Resonator (9-1) für die emittierte IR-Strahlung bildet.

15. Der thermische Emitter gemäß einem der Ansprüche 3 bis 14, wobei der thermische Emitter einen MEMS-IR-Emitter mit einer Betriebstemperatur in dem Bereich zwischen 800 und 1100 °C bildet.

16. Ein MEMS-Gas- oder -Fluidsensor, der folgende Merkmale aufweist:
einen thermischen Emitter zum Emittieren von thermischer Strahlung gemäß einem der vorhergehenden Ansprüche,
ein Messvolumen, das ein Zielgas oder ein Zielfluid aufweist und einen Optische-Wechselwirkung-Pfad für die emittierte thermische Strahlung bereitstellt,
und
einen akustischen Wandler oder einen thermischen Direktdetektor zum Bereitstellen eines Detektorausgangssignals basierend auf der optischen Wechselwirkung der emittierten thermischen Strahlung mit dem Zielgas oder dem Zielfluid in dem Messvolumen.

## Revendications

1. Un émetteur (1) thermique comprenant :
une membrane (2) autonome supportée par un substrat (3), dans lequel la membrane (2) autonome comprend dans une étendue latérale une partie (2-1) centrale, une partie (2-2) intermédiaire conductrice de l'électricité et une partie (2-3) de bordure,
dans lequel la partie (2-2) intermédiaire conductrice de l'électricité entoure latéralement la partie (2-1) centrale, dans lequel la partie (2-2) intermédiaire conductrice de l'électricité est isolée électriquement de la partie (2-1) centrale et est couplée thermiquement à la partie (2-1) centrale, dans lequel la partie (2-2) intermédiaire conductrice de l'électricité comprend une pluralité de couches, dans lesquelles une couche (10-2) à semiconducteur conductrice de l'électricité est passivée dans un matériau (12) isolant, et dans lequel la partie (2-2) intermédiaire conductrice de l'électricité forme un chemin de courant dérivé séparé par la partie (2-1) centrale et forme un élément chauffant, qui produit de la chaleur pendant un état activé, la chaleur se répandant dans la partie (2-1) centrale, dans lequel la partie (2-1) centrale est une structure de diffusion de la chaleur ayant un matériau très conducteur de la chaleur d'une conductivité thermique k ≥ 30 W/m*K à 298°C, et
dans lequel la partie (2-3) de bordure entoure au moins en partie la partie (2-2) intermédiaire conductrice de l'électricité et est isolée électriquement de la partie (2-2) intermédiaire conductrice de l'électricité, une perforation (4) étant formée dans la partie (2-3) de bordure.

2. L'émetteur thermique de la revendication 1, dans lequel la membrane (2) autonome s'étend sous la forme d'une pile de couches parallèlement à une région (3-1) de surface principale du substrat (3).

3. L'émetteur thermique de l'une quelconque des revendications précédentes, dans lequel la couche à semiconducteur conductrice de la partie (2-2) intermédiaire conductrice de la membrane (2) autonome est une couche à semiconducteur fortement dopée, qui est passivée dans le matériau isolant, dans lequel le matériau semiconducteur conducteur comprend un polysilicium ou un silicium monocristallin, et dans lequel le matériau isolant comprend du nitrure de silicium.

4. L'émetteur thermique de l'une quelconque des revendications précédentes, dans lequel la partie (2-2) intermédiaire conductrice de la membrane (2) autonome s'étend entre deux régions (5-1, 5-2) opposées latéralement de bord de la membrane (2) autonome.

5. L'émetteur thermique de l'une quelconque des revendications précédentes, dans lequel la partie (2-2) intermédiaire conductrice de la membrane (2) autonome comprend une pluralité de bras (2-2-1, 2-2-2, ..., 2-2-n) conducteurs, qui s'étendent entre une pluralité de régions (5-1, 5-2, ..., 5-n) associées de bord de la membrane (2) autonome, dans lequel la pluralité de bras (2-2-1, 2-2-2, ..., 2-2-n) de la partie (2-2) intermédiaire conductrice et les régions (5-1, 5-2, ..., 5-n) de bord de la membrane (2) autonome, sont disposées symétriquement par rapport à une ligne (AA) de symétrie passant par le point central de la partie 2-1 centrale.

6. L'émetteur thermique de l'une quelconque des revendications précédentes, dans lequel la partie (2-1) centrale et la partie (2-2) intermédiaire de la membrane (2) autonome sont disposées sur une cavité (6) dans le substrat (3).

7. L'émetteur thermique de la revendication 6, dans lequel la membrane (2) autonome recouvre la cavité (6) dans le substrat (3), dans lequel la partie (2-3) de bordure de la membrane (2) autonome est fixée au substrat (3).

8. L'émetteur thermique de l'une quelconque des revendications précédentes, dans lequel le substrat (3) comprend un substrat (7) à semiconducteur non épitaxié et une couche (8) isolante, dans lequel la couche (8) isolante forme une région (3-1) de surface principale du substrat (3), à laquelle la membrane (2) autonome est fixée.

9. L'émetteur thermique de l'une quelconque des revendications précédentes, dans lequel la perforation (4) dans la partie (2-3) de bordure forme un trou de ventilation ou une pluralité de trous de ventilation dans la membrane (2) autonome.

10. L'émetteur thermique de l'une quelconque des revendications précédentes, dans lequel la partie (2-3) de bordure de la membrane (2) autonome comprend une couche à semiconducteur encapsulée dans un matériau isolant comprenant une couche de matériau isolant.

11. L'émetteur thermique de l'une quelconque des revendications précédentes, dans lequel la partie (2-1) centrale de la . membrane (2) autonome comprend une couche à semiconducteur encapsulée dans un matériau isolant ou comprend une couche de matériau isolant.

12. L'émetteur thermique de l'une quelconque des revendications précédentes, dans lequel la partie (2-1) centrale de la membrane (2) autonome est une structure en forme de disque de diffusion de la chaleur.

13. L'émetteur thermique de l'une quelconque des revendications précédentes, comprenant une structure (9) plasmonique sur la partie (2-1) centrale et la partie (2-2) intermédiaire conductrice de la membrane (2) autonome, dans lequel la structure (9) plasmonique forme un filtre à bande passante pour un rayonnement IR émis par la membrane (2) autonome pendant un fonctionnement de l'émetteur thermique.

14. L'émetteur thermique de la revendication 13, dans lequel la structure (9) plasmonique forme un résonateur (9-1) plasmonique pour le rayonnement IR émis.

15. L'émetteur thermique de l'une quelconque des revendications 3 à 14, dans lequel l'émetteur thermique forme un émetteur IR MEMS ayant une température de fonctionnement dans la plage comprise entre 800 et 1100°C.

16. Un détecteur MEMS de gaz ou de fluide, comprenant :
un émetteur thermique pour émettre du rayonnement thermique suivant l'une quelconque des revendications précédentes,
un volume de mesure ayant un gaz cible ou un fluide cible et donnant un chemin d'interaction optique pour le rayonnement thermique émis,
et .
un transducteur acoustique ou un détecteur thermique direct pour donner un signal de sortie de détecteur sur la base de l'interaction optique du rayonnement thermique émis par le gaz cible ou le fluide cible dans le volume de mesure. .
